# FASCICULE DE BREVET EUROPEEN

(11) **EP 3 254 319 B1**
(45) Date de publication et mention de la délivrance du brevet: **27.03.2019**
(21) Numéro de dépôt: 16703471.9
(22) Date de dépôt: 02.02.2016
(51) Int. Cl.: H01M 2/10

(54) **ABRI STATIONNAIRE DE STOCKAGE D'AU MOINS UN ÉLÉMENT DE STOCKAGE D'ÉNERGIE**
STATIONÄRER SCHUTZ ZUR AUFBEWAHRUNG VON MINDESTENS EINEM ENERGIESPEICHERELEMENT
STATIONARY SHELTER FOR STORING AT LEAST ONE ENERGY STORAGE ELEMENT

(30) Priorité: 03.02.2015 FR 1550838
(43) Date de publication de la demande: 13.12.2017
(73) Titulaire: Blue Solutions, 29500 Ergué Gabéric (FR)
(72) Inventeur: JOURDREN, Arnaud, 29500 Ergue Gaberic (FR); MAS, Pierre, 29000 Quimper (FR)
(74) Mandataire: Regimbeau
(86) Numéro de dépôt international: PCT/EP2016/052160
(87) Numéro de publication internationale: WO 2016/124582

(56) Documents cités:
- EP-A1- 2 663 482
- US-A- 4 331 369
- US-A1- 2007 278 918

## Description

### DOMAINE TECHNIQUE GENERAL

L'invention se situe dans le domaine des installations électriques autonomes et stationnaires, c'est-à-dire des installations fixes, qui couplent des panneaux solaires ou des éoliennes par exemple, avec des éléments de stockage de l'énergie électrique ainsi produite.

L'invention concerne plus particulièrement un abri stationnaire de stockage d'au moins l'un de ces éléments.

### ETAT DE L'ART

Les installations électriques précitées sont destinées à être installées dans des zones reculées, difficiles d'accès, par exemple mais non exclusivement en Afrique.

Des "abris", connus sous la dénomination anglaise de "shelters", permettent de loger non seulement un ensemble d'éléments de stockage d'énergie, mais également divers dispositifs assurant la gestion électronique de leur fonctionnement et de leur sécurité.

On connait déjà dans l'état de la technique, de tels abris de stockage, qui présentent au moins deux parois verticales, dont les faces en regard l'une de l'autre sont munies de cornières réparties régulièrement sur la hauteur des parois et sur lesquelles on vient engager lesdits éléments de stockage d'énergie par glissement.

En pratique, l'introduction des éléments de stockage d'énergie (ci-après « éléments ») dans l'abri s'effectue comme suit. Un transporteur décharge les caisses contenant les éléments à proximité de l'abri. Les caisses sont ouvertes, puis l'opérateur arrime un cadre de levage solidaire d'un chariot élévateur à l'élément à déplacer. À l'aide du chariot élévateur, l'opérateur déplace l'élément sur des madriers posés au sol puis le détache du cadre de levage. Il insère les fourches du chariot élévateur sous l'élément et le soulève pour l'amener en regard des cornières latérales de l'abri. Ensuite, l'opérateur actionne le chariot élévateur pour insérer l'élément horizontalement dans l'abri de stockage, tout en veillant à ce que les ailettes ménagées sur les faces latérales de l'élément soient alignées avec lesdites cornières et glissent sur celles-ci.

Toutefois, cette opération nécessite en fait deux opérateurs, l'un aux commandes du chariot élévateur et l'autre à proximité de l'abri, plus particulièrement en regard du côté de l'insertion de l'élément de stockage d'énergie, pour diriger la manoeuvre.

De plus, pendant le déplacement, la sécurité n'est plus assurée puisque l'élément n'est plus fixé au cadre de levage et qu'il existe toujours un risque que l'élément glisse sur les fourches du chariot.

Par ailleurs, lorsque l'abri de stockage est installé dans des zones d'accès difficile, il peut se trouver sur tout type de terrain, par exemple accidenté, caillouteux, il peut même être sur le sol à une hauteur différente de celle à laquelle se trouve le chariot élévateur. Dans ces différents cas, et en prenant également en compte les conditions météo, la demanderesse a constaté que le chargement et le déchargement des éléments de stockage d'énergie dans et hors de l'abri de stockage peut s'avérer dangereux et très complexe.

Enfin, ces opérations de manutention peuvent même engendrer des dégradations de l'abri ou de l'élément de stockage d'énergie si cet dernier est engagé en biais par rapport aux cornières de l'abri.

### PRESENTATION DE L'INVENTION

L'invention a donc pour but de résoudre les inconvénients précités de l'état de la technique et de permettre un chargement ou un déchargement des éléments de stockage d'énergie dans et hors de l'abri, qui soit sécurisé pour l'opérateur et sans risques d'endommagements de cet élément ou de cet abri.

L'invention a également pour but de simplifier ces opérations de manutention et de permettre leur mise en oeuvre avec peu d'outils et un seul opérateur.

À cet effet, l'invention concerne un abri stationnaire de stockage d'au moins un élément de stockage d'énergie, dit « élément » E, comprenant au moins un emplacement de stockage d'un élément.

Conformément à l'invention, cet abri comprend un support coulissant de part et d'autre de chaque emplacement de stockage, les deux supports coulissants étant disposées à la même hauteur et en regard l'un de l'autre, chaque support coulissant comprend une partie fixe solidaire dudit abri et une partie mobile configurée pour recevoir et supporter ledit élément E et pour pouvoir coulisser par rapport à ladite partie fixe entre une position rentrée, dans laquelle elle se trouve à l'intérieur de l'abri et une position sortie, dans laquelle elle se trouve à l'extérieur de l'abri et permet le chargement et le déchargement dudit élément E par le haut et au moins l'un des supports coulissants est équipé de moyens de verrouillage de la partie mobile en position sortie.

Grâce à ces caractéristiques de l'invention, le chargement et le déchargement de l'élément de stockage d'énergie est sécurisé puisqu'il peut se faire par le haut alors que l'élément est encore accroché au chariot élévateur via tout type de système de levage et que la partie mobile des supports coulissants est immobilisée.

De plus, le positionnement des éléments de stockage d'énergie se fait par rapport aux supports coulissants, plus particulièrement par rapport à leurs parties mobiles, et comme la position des supports coulissants reste constamment identique (c'est-à-dire perpendiculaire à l'abri) quel que soit l'état du terrain sur lequel est placé l'abri, lesdits éléments sont toujours positionnés correctement dans l'abri, sans risque d'endommagement.

Selon d'autres caractéristiques avantageuses et non limitatives de l'invention, prises seules ou en combinaison :
- la partie mobile du support coulissant configurée pour supporter l'élément E est une équerre présentant la forme d'une cornière en L dont l'aile horizontale permet de supporter au moins une partie de l'élément E, de préférence une ailette latérale de celui-ci ;
- lesdits supports coulissants sont télescopiques et comprennent au moins une partie mobile intermédiaire insérée entre la partie fixe et ladite partie mobile support de l'élément E ;
- le support coulissant comprend une latte de fixation, une glissière et une équerre présentant la forme d'une cornière en L dont l'aile horizontale permet de supporter au moins une partie de l'élément E, de préférence une ailette latérale de celui-ci, ladite glissière comprenant un rail de guidage ayant la forme d'un profilé en I, muni de deux réglettes coulissantes aptes à coulisser de part et d'autre dudit rail de guidage la latte de fixation et l'une des réglettes coulissantes constituant la partie fixe du support coulissant, le rail de guidage constituant la partie mobile intermédiaire du support coulissant et l'autre réglette coulissante et l'équerre constituant la partie mobile support de l'élément E du support coulissant ;
- les parties mobiles support de l'élément E de deux supports coulissants situés de part et d'autre d'un emplacement de stockage sont reliées entre elles par au moins une traverse de façon à former un berceau ;
- les moyens de verrouillage de la partie mobile du support coulissant en position sortie comprennent un levier monté pivotant par rapport à la partie mobile du support coulissant qui supporte l'élément E, ce levier présentant une encoche apte à recevoir un pion de verrouillage solidaire de l'abri et ledit levier est mobile entre une position verrouillée, dans laquelle le pion de verrouillage est logé dans l'encoche et dans laquelle ladite partie mobile du support coulissant est immobilisée en position sortie, et une position déverrouillée, dans laquelle le pion de verrouillage est hors de l'encoche et dans laquelle la partie mobile du support coulissant est mobile ;
- la partie mobile support de l'élément E du support coulissant comprend au moins un guide de positionnement latéral de l'élément E ;
- la partie mobile support de l'élément E du support coulissant comprend au moins une cale de positionnement avant et une cale de positionnement arrière de l'élément E ;
- au moins l'un des supports coulissants est équipé de moyens de verrouillage de la partie mobile support de l'élément E en position rentrée ; et
- lesdits moyens de verrouillage comprennent un manchon tubulaire solidaire de ladite partie mobile support de l'élément E et un doigt de verrouillage mobile en translation à l'intérieur dudit manchon tubulaire et armé à ressort, la partie fixe du support coulissant présente un logement de réception de l'extrémité extérieure dudit doigt de verrouillage, le ressort tend en permanence à maintenir l'extrémité extérieure du doigt de verrouillage dans le logement de réception de la partie fixe du support coulissant, en immobilisant ainsi la partie mobile du support coulissant en position rentrée et le doigt de verrouillage peut être déplacé à l'encontre de la force de rappel du ressort pour que son extrémité extérieure sorte dudit logement de réception, en libérant ainsi ladite partie mobile du support coulissant.

### PRESENTATION DES FIGURES

D'autres caractéristiques et avantages de l'invention apparaîtront de la description qui va maintenant en être faite, en référence aux dessins annexés, qui en représentent, à titre indicatif mais non limitatif, un mode de réalisation possible.

Sur ces dessins :
- la figure 1 est une vue en perspective et en coupe partielle d'une partie d'un abri de stockage d'au moins un élément de stockage d'énergie conforme à l'invention,
- la figure 2 est une vue en perspective d'un exemple de réalisation d'une structure de stockage conforme à l'invention, destinée à être logée dans l'abri,
- la figure 3 est une vue en perspective éclatée d'un support coulissant et d'un berceau de stockage conforme à l'invention,
- la figure 4 est une vue de détail et en perspective du dispositif de verrouillage de la partie mobile du support coulissant en position sortie, et
- la figure 5 est une vue de détail et en perspective du dispositif de verrouillage de la partie mobile du support coulissant en position rentrée.

### DESCRIPTION DETAILLEE

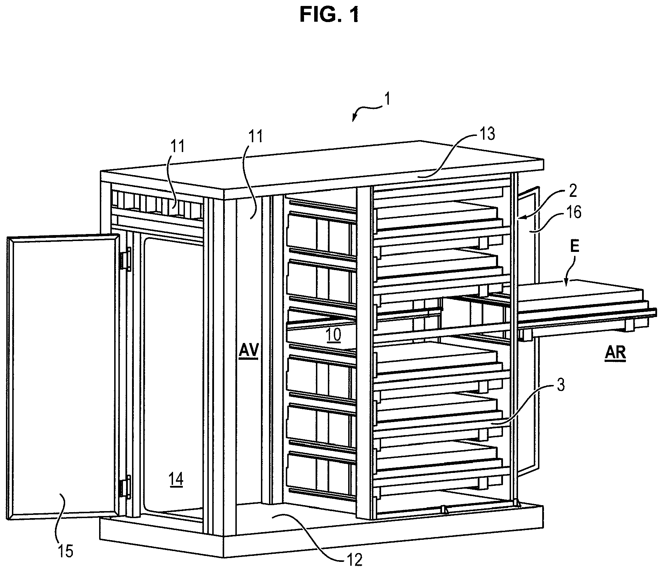

En se reportant à la figure 1, on peut voir un abri stationnaire de stockage 1 comprenant au moins un emplacement de stockage 10 d'un élément de stockage d'énergie E (ci-après dénommé « élément ») (six emplacements sur l'exemple représenté sur la figure).

Cet abri de stockage 1 peut être par exemple un petit bâtiment dont les murs sont en béton ou autre matériau de construction, un conteneur dont les murs sont réalisés en métal (comme représenté sur la figure) ou plus simplement une armoire de stockage.

L'abri 1 comprend plusieurs parois verticales périphériques 11, un plancher (ou fond) 12 et un toit 13, qui ensemble délimitent une enceinte 14. En outre, l'abri 1 est muni d'au moins une porte d'accès 15 à l'intérieur de l'enceinte, plus particulièrement au local électrotechnique de l'abri, et d'au moins une porte d'accès 16 auxdits éléments, de préférence une double porte à deux battants, c'est-à-dire une porte placée en regard de l'une des faces des éléments E, plus particulièrement dans le sens d'ouverture des supports coulissants sur lesquels sont agencés les éléments E, comme décrit plus en détails ci-après. Enfin, l'abri 1 peut éventuellement comprendre au moins une paroi verticale intermédiaire, à l'intérieur de l'enceinte 14, une telle paroi n'étant pas représentée sur les figures.

Cet abri 1 est destiné, entre autres, à protéger les éléments E des intempéries et assurer une enceinte climatique stable.

L'abri de stockage 1 est dit "stationnaire", en ce sens qu'il est fixe et n'est pas embarqué sur un véhicule mobile.

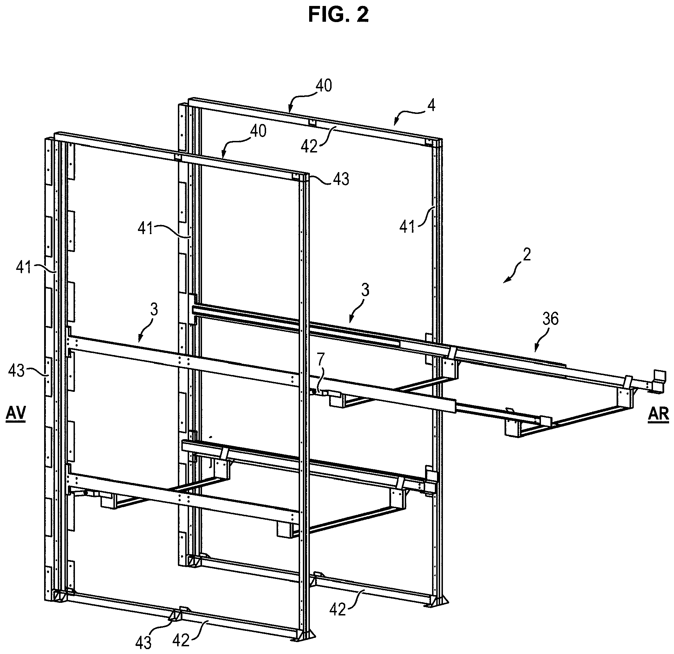

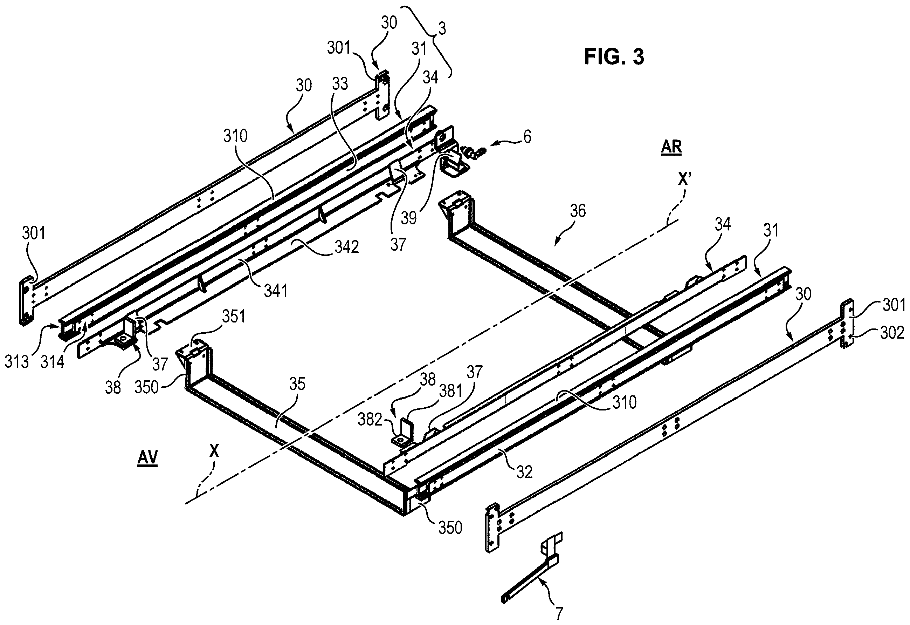

Une structure 2 de support et stockage des éléments E est destinée à être positionnée dans l'abri 1. Elle va maintenant être décrite en faisant référence aux figures 2 et 3.

La structure 2 comprend au moins une paire de supports coulissants 3, fixés à la même hauteur sur un support 4 lui-même fixé sur le plancher et le toit de l'abri 1, et éventuellement sur les parois de l'abri 1.

Dans une variante de réalisation simplifiée non représentée sur les figures, la structure 2 peut ne comprendre que des paires de supports coulissants 3 qui sont alors fixées directement sur les parois verticales périphériques 11 de l'abri 1.

Dans la variante de réalisation représentée sur les figures, le support 4 comprend deux cadres 40. De façon avantageuse, chaque cadre 40 est constitué par l'assemblage de deux montants verticaux 41 et de deux longerons horizontaux 42. Le cadre 40 est en outre muni d'une pluralité de pattes de fixation 43 permettant de le rendre solidaire du plancher 12, du toit 13 et éventuellement de l'une des parois 11 de l'abri 1. Les deux cadres 40 pourraient également être reliés entre eux par des traverses horizontales.

En se reportant à la figure 3, on va maintenant décrire un mode de réalisation possible du support coulissant 3, qui dans ce cas est télescopique.

Chaque support coulissant 3 comprend une latte de fixation 30, une glissière 31 et une équerre 34 support de l'élément E. Chaque glissière 31 comprend un rail de guidage 310 qui assure le guidage de deux réglettes coulissantes 32 et 33.

La latte de fixation 30 est un profilé en forme de lame rectiligne rigide ayant deux extrémités 301 en T.

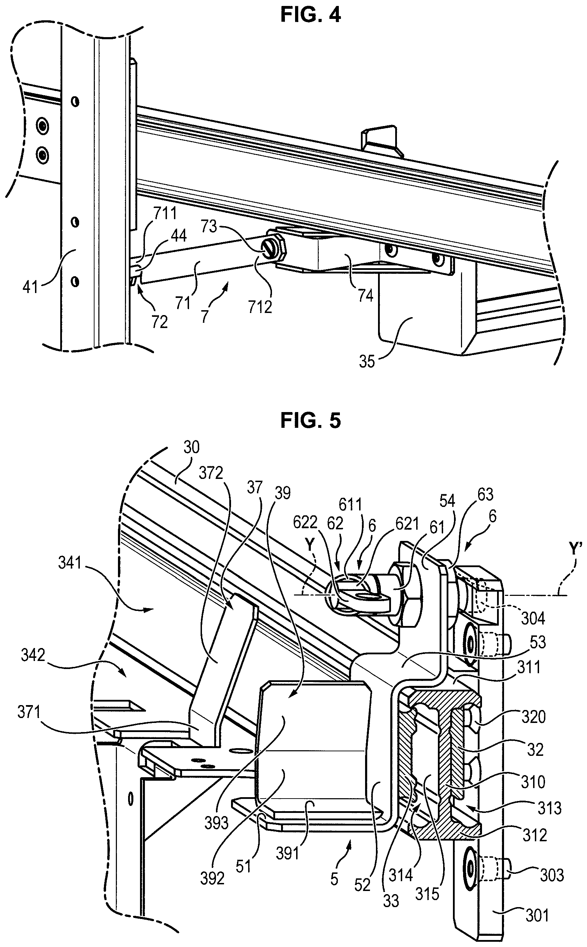

De préférence, les extrémités 301 en T sont munies de perçages 302, permettant le passage de vis de fixation 303 de la latte 30 sur les montants 41 du support 4 ou sur les parois verticales 11 de l'abri 1. Les vis 303 sont visibles uniquement sur la figure 5.

Le rail de guidage 310 est un profilé en I comme cela apparait mieux sur la figure 5. Ce profilé présente une âme centrale verticale 315 et deux branches horizontales perpendiculaires à l'âme 315, à savoir une branche supérieure 311 et une branche inférieure 312.

Les deux extrémités de la branche supérieure 311 sont légèrement recourbées respectivement vers les deux extrémités de la branche inférieure 312, de sorte qu'elles définissent avec chaque face de l'âme centrale 315, deux gorges opposées 313 et 314 de réception et de guidage en coulissement respectivement des deux réglettes coulissantes 32 et 33.

La réglette coulissante 32 est celle qui est tournée vers la latte de fixation 30 et elle est fixée sur celle-ci par exemple par vissage à l'aide de vis 320. La réglette coulissante 32 constitue avec la latte 30, la partie fixe du support coulissant 3. Le rail de guidage 310 est mobile en translation par rapport à la réglette 32 et la réglette 33 est elle-même coulissante par rapport au rail de guidage 310, lequel constitue ainsi la partie mobile intermédiaire du support coulissant 3 télescopique.

Des chemins de billes non visibles sur les figures permettent le coulissement des réglettes 32, 33 par rapport au rail de guidage 310. Des butées non visibles sur les figures limitent la course des réglettes 32, 33 par rapport au rail de guidage 310 de façon à les empêcher de sortir dudit rail 310.

L'équerre 34 est un profilé en L (cornière) qui présente une aile verticale 341 et une aile horizontale 342 (voir figure 3).

L'aile horizontale 342 est d'une largeur suffisante pour recevoir et supporter au moins une partie de l'élément E, de préférence une ailette horizontale ménagée sur les côtés verticaux de l'élément E.

En outre, les deux supports coulissants 3 sont espacés l'un de l'autre d'une distance qui correspond aux dimensions (par exemple à la largeur) de l'élément E. Ainsi, l'élément E peut être inséré par le haut, de façon que ses ailettes horizontales reposent sur les deux ailes horizontales 342 de la paire de supports coulissants 3 disposés de part et d'autre d'un emplacement 10.

On notera également que si les éléments E ne présentent pas d'ailes, ils peuvent être disposés de façon que leur fond repose directement sur les ailes horizontales 342 ou sur le fond d'un berceau, comme décrit ci-après.

L'aile verticale 341 est fixée à la réglette coulissante 33 dont elle est solidaire en translation.

De façon avantageuse, au moins une traverse 35, (de préférence deux comme représenté sur les figures 2 et 3), est fixée entre les deux équerres coulissantes 34.

La traverse 35 est de préférence constituée d'un profilé plan horizontal recourbé verticalement à ses deux extrémités 350, puis recourbé de nouveau horizontalement vers l'extérieur afin de définir deux pattes de fixation 351. Ces pattes de fixation 351 peuvent être fixées, par exemple par vissage, à chacune des équerres 34, plus précisément à leurs ailes horizontales respectives 342.

Ces traverses 35 permettent de rendre les deux équerres 34 solidaires et donc de les faire se déplacer conjointement et, par ailleurs, elles peuvent servir également de support pour les éléments E.

Deux supports coulissants 3 situés à la même hauteur sur le support 4 et les éventuelles traverses 35, si elles sont présentes, constituent un berceau 36 de réception d'un élément E. Le berceau 36 présente un axe longitudinal X-X'.

De préférence, chaque équerre 34 est munie d'au moins un guide latéral 37, de préférence encore de deux guides latéraux 37, comme représenté sur les figures.

Ce guide latéral 37 est par exemple formé d'une languette, venue de matière avec l'aile horizontale 342 et recourbée verticalement vers le haut (partie verticale 371) puis une deuxième fois vers l'aile verticale 341 (partie évasée 372), de façon à présenter une forme évasée vers le haut et vers l'extérieur du berceau 36 (voir figure 5).

Les guides 37 de chaque équerre 34 sont disposés préférentiellement l'un en face de l'autre par paire. L'écartement entre les deux parties verticales 371 correspond sensiblement à la plus grande largeur de l'élément E, au jeu près permettant l'introduction de celle-ci entre les guides 37. La partie évasée 372 permet le guidage de l'élément E lors de son positionnement dans le berceau 36 qui s'effectue du haut vers le bas.

De préférence également, chaque équerre 34 est munie d'une cale avant 38 et d'une cale arrière 39 qui ont pour fonction de positionner l'élément E longitudinalement (selon l'axe X-X'). La cale avant 38 est située du côté avant AV du berceau 36, qui correspond également au côté avant AV du support 4, c'est-à-dire le côté à l'intérieur de l'abri vers lequel se rentrent les parties mobiles du support coulissant 3.

La cale avant 38 est par exemple constituée d'un profilé en L dont l'aile verticale 381 sert de butée à l'élément E et dont l'aile horizontale 382 est fixée, par exemple par vissage, à l'équerre 34, et dans l'exemple de réalisation représenté à la figure 3, à l'aile horizontale 342.

La cale arrière 39 peut présenter une structure et une fixation similaire à la cale avant 38 mais en étant disposée vers l'arrière AR de l'équerre 34.

Toutefois, dans la variante de réalisation représentée sur les figures 3 et 5, la cale arrière 39 n'est pas fixée directement sur l'équerre 34 mais sur une patte de fixation 5 elle-même fixée sur l'aile verticale 341 de l'équerre 34. Cette patte de fixation 5 est également utilisée pour fixer des moyens optionnels de verrouillage 6 de l'équerre 34 en position rentrée, qui seront décrits ultérieurement.

La patte de fixation 5 est un profilé plat, replié trois fois à angle droit, de façon à former successivement une partie support horizontale 51, une partie verticale 52 fixée à l'aile verticale 341, une partie horizontale 53 qui s'étend au-dessus et à légère distance de la branche 311 du rail de guidage 310 et enfin, une partie verticale 54 sur laquelle sont fixés lesdits moyens de verrouillage 6. La patte de fixation 5 est donc solidaire en translation de l'équerre 34.

La cale arrière 39 est un profilé en L présentant une branche horizontale 391 fixée à la partie 51, par exemple par vissage et une branche verticale 392 qui coopère avec l'aile verticale 381 de la cale avant 38 pour caler l'élément E dans le sens longitudinal. De façon avantageuse, la branche verticale 392 se prolonge par une partie 393 inclinée vers l'arrière qui facilite l'introduction de l'élément E par le haut du berceau 36.

La variante du support coulissant 3 qui vient d'être décrite est un support coulissant télescopique qui présente l'avantage de permettre l'extraction complète de l'équerre 34 hors du support 4, ce qui facilite grandement l'introduction ou l'extraction de l'élément E. Toutefois, dans un autre mode de réalisation, le support coulissant 3 peut ne pas être télescopique et comprendre uniquement une partie fixe et une partie support de l'élément E, coulissante et mobile par rapport à ladite partie fixe, dès lors que la partie coulissante mobile peut être extraite suffisamment du support 4 ou de l'abri 1 pour permettre la manipulation de l'élément E.

Conformément à l'invention, chaque support coulissant 3 est équipé de moyens de verrouillage 7 de sa partie mobile, ici de l'équerre 34, lorsqu'elle se trouve en position "sortie", c'est-à-dire lorsqu'elle est au maximum de sa course hors du rail de guidage 310 (position représentée en partie haute de la figure 2).

Un mode de réalisation possible de ces moyens 7 est représenté sur la figure 4.

Il s'agit d'un levier pivotant 71, muni à l'une de ses extrémités 711 d'une encoche 72 débouchant vers le bas. Ce levier est monté pivotant à son autre extrémité 712 autour d'un axe 73, solidaire d'une patte de fixation 74, elle-même fixée à l'équerre 34, plus précisément à la traverse 35.

Par ailleurs, un pion de verrouillage horizontal 44 est fixé sur la face intérieure de l'un des montants verticaux 41 du support 4, voire même directement sur l'une des parois verticales 11 de l'abri 1 si le support 4 n'est pas présent.

Lorsque l'opérateur fait coulisser l'équerre 34 vers l'arrière, en position sortie, le levier 71, qui pend vers le bas par gravité arrive en contact du pion 44, coulisse sur le pion grâce à l'axe de rotation, jusqu'à ce que l'encoche 72 vienne crocheter le pion 44, bloquant alors le coulissement du berceau 36 - ce qui correspond alors à la position sortie du berceau 36 (voir figure 4).

L'opérateur peut alors accrocher l'élément E au cadre de levage solidaire du chariot élévateur et introduire l'élément E à l'intérieur du berceau 36, en étant sûr que les équerres 34 situées de part et d'autre resteront immobiles pendant la manipulation.

De plus, l'élément E étant amené par le haut pour être déposé sur les équerres 34 (et éventuellement les traverses 35 si elles sont présentes), il peut rester fixé au cadre de levage du chariot élévateur pendant toute la manipulation. La manipulation de l'élément E est donc beaucoup plus fiable qu'avec le procédé de l'état de la technique précédemment décrit.

Ensuite, l'opérateur peut soulever manuellement le levier 71 pour le libérer du pion de verrouillage 44 et repousser le berceau 36 et les équerres 34 vers l'avant AV de l'abri 1. Les équerres 34 étant disposées dans un plan horizontal, l'opérateur est sûr que l'élément E sera engagé correctement dans l'abri 1 sans risquer d'endommager l'élément E ou les parois de l'abri.

Enfin, de façon avantageuse, la structure comprend également des moyens de verrouillage 6 de l'équerre 34 en position rentrée, qui vont maintenant être décrits en liaison avec la figure 5.

Ces moyens 6 comprennent un manchon 61 tubulaire creux et un doigt de verrouillage 62. Le manchon 61 est fixé au travers de la partie verticale 54 de la patte de fixation 5, par exemple à l'aide d'écrous 63. Il s'étend selon un axe longitudinal Y-Y'. L'extrémité 611 du manchon 61 orientée vers l'intérieur du berceau 36 est biseautée. Le manchon 61 est donc fixé à l'extrémité arrière de l'équerre 34.

Le doigt de verrouillage 62 comprend une tige 621 insérée axialement dans le manchon 61 avec un faible jeu qui autorise son pivotement et son coulissement le long de l'axe Y-Y'. En outre, la tige 621 est montée dans le manchon 61 par l'intermédiaire d'un ressort de rappel non représenté sur les figures.

La tige 621 est munie à son extrémité intérieure, c'est-à-dire orientée vers l'intérieur du berceau 36, d'une manette de manoeuvre 622 qui lui est perpendiculaire.

Enfin, l'extrémité arrière 301 en T de la latte de fixation 30 comprend un perçage 304, de préférence un trou oblong, perpendiculaire à l'axe X-X'. Le perçage pourrait également être prévu directement dans la paroi verticale de l'abri située en regard des supports coulissants 3. Les deux extrémités 301 en T arrière et avant de la latte 30 peuvent également présenter le perçage 304 pour assurer la réversibilité de la latte de fixation 30.

Dans la position verrouillée du doigt 62 représentée sur la figure 5, la tige 621 est enfoncée complètement à l'intérieur du manchon 61 de sorte que son extrémité extérieure pénètre dans le perçage 304 qui fait office de logement. Dans cette position, le ressort à l'intérieur du manchon 61 est dans sa position de repos non sollicité en compression, ou de préférence légèrement comprimé. De même, dans cette position, l'équerre 34 solidaire de la patte 5 et du manchon 61 est immobilisée par rapport à la latte de fixation 30 et est donc verrouillée au fond de l'abri 1. Si un élément E se trouve dans le berceau alors que les équerres 34 sont verrouillées en position rentrée, l'opérateur est sûr que l'élément E est correctement immobilisée dans l'abri 1.

Pour déverrouiller cette position et entamer le coulissement du berceau 36 vers l'arrière, l'opérateur peut alors tirer sur la manette 622 selon l'axe Y-Y' et la faire pivoter d'un quart de tour. La manette 622 glisse alors le long de l'extrémité biseauté 611 et se faisant la tige 621 recule en direction de l'intérieur du berceau 36, ce qui a pour effet de la libérer du perçage 304, d'armer le ressort de rappel et de déverrouiller l'équerre 34. Le berceau peut alors être de nouveau manipulé en coulissement vers l'arrière, notamment pour le faire sortir de l'abri 1.

Inversement, lorsque l'opérateur ramène le berceau au fond de l'abri, le ressort tend à ramener la tige 621 en position verrouillée.

On notera que les moyens de verrouillage 6 pourraient également être disposés du côté avant du berceau 36.

Les éléments de stockage d'énergie électrique E dont il est question dans la présente demande sont préférentiellement des batteries de stockage d'énergie électrique, du type LMP (Lithium Métal Polymère) ou du type lithium ions, dont le poids est de l'ordre de 350kg.

Le berceau 36 est avantageusement dimensionné de sorte à supporter des charges comprises entre 300kg et 400kg.

Bien que sur la figure 1, l'élément de stockage d'énergie E rectangulaire ait été représenté comme étant supporté par ses grands côtés, il pourrait également être supporté par ses petits côtés. Dans ce cas, les supports coulissants 3 sont moins longs, l'emplacement 10 est plus large et les deux supports coulissants 3 d'une même paire sont plus espacés l'un de l'autre.

## Revendications

1. Abri stationnaire de stockage (1) d'au moins un élément de stockage d'énergie, dit « élément » (E), comprenant au moins un emplacement (10) de stockage d'un élément, **caractérisé en ce qu'**il comprend un support coulissant (3) de part et d'autre de chaque emplacement de stockage (10), les deux supports coulissants (3) étant disposés à la même hauteur et en regard l'un de l'autre, **en ce que** chaque support coulissant (3) comprend une partie fixe (30, 32) solidaire dudit abri (1) et une partie mobile (34, 36) configurée pour recevoir et supporter ledit élément (E) et pour pouvoir coulisser par rapport à ladite partie fixe (30, 32) entre une position rentrée, dans laquelle elle se trouve à l'intérieur de l'abri (1) et une position sortie, dans laquelle elle se trouve à l'extérieur de l'abri (1) et permet le chargement et le déchargement dudit élément (E) par le haut et **en ce qu'**au moins l'un des supports coulissants (3) est équipé de moyens de verrouillage (7) de la partie mobile (34, 36) en position sortie.

2. Abri selon la revendication 1, **caractérisé en ce que** la partie mobile (34) du support coulissant (3) configurée pour supporter l'élément (E) est une équerre présentant la forme d'une cornière en L dont l'aile horizontale (342) permet de supporter au moins une partie de l'élément (E), de préférence une ailette latérale de celui-ci.

3. Abri selon la revendication 1 ou 2, **caractérisé en ce que** lesdits supports coulissants (3) sont télescopiques et comprennent au moins une partie mobile intermédiaire (31) insérée entre la partie fixe (30, 32) et ladite partie mobile (34, 36) support de l'élément (E).

4. Abri selon la revendication 3, **caractérisé en ce que** le support coulissant (3) comprend une latte de fixation (30), une glissière (31) et une équerre (34) présentant la forme d'une cornière en L dont l'aile horizontale (342) permet de supporter au moins une partie de l'élément (E), de préférence une ailette latérale de celui-ci, ladite glissière (31) comprenant un rail de guidage (310) ayant la forme d'un profilé en I, muni de deux réglettes coulissantes (32, 33) aptes à coulisser de part et d'autre dudit rail de guidage (310), la latte de fixation (30) et l'une (32) des réglettes coulissantes constituant la partie fixe du support coulissant (3), le rail de guidage (310) constituant la partie mobile intermédiaire du support coulissant (3) et l'autre réglette coulissante (33) et l'équerre (34) constituant la partie mobile support de l'élément (E) du support coulissant (3).

5. Abri selon l'une des revendications précédentes, **caractérisé en ce que** les parties mobiles (34) support de l'élément (E) de deux supports coulissants (3) situés de part et d'autre d'un emplacement de stockage (10) sont reliées entre elles par au moins une traverse (35) de façon à former un berceau (36).

6. Abri selon l'une des revendications précédentes, **caractérisé en ce que** les moyens de verrouillage (7) de la partie mobile du support coulissant (3) en position sortie comprennent un levier (71) monté pivotant par rapport à la partie mobile (34) du support coulissant qui supporte l'élément (E), ce levier (71) présentant une encoche (72) apte à recevoir un pion de verrouillage (44) solidaire de l'abri (1), et **en ce que** ledit levier (71) est mobile entre une position verrouillée, dans laquelle le pion de verrouillage (44) est logé dans l'encoche (72) et dans laquelle ladite partie mobile (34) du support coulissant est immobilisée en position sortie, et une position déverrouillée, dans laquelle le pion de verrouillage (44) est hors de l'encoche (72) et dans laquelle la partie mobile (34) du support coulissant est mobile.

7. Abri selon l'une des revendications précédentes, **caractérisé en ce que** la partie mobile (34) support de l'élément (E) du support coulissant comprend au moins un guide de positionnement latéral (37) de l'élément (E).

8. Abri selon l'une des revendications précédentes, **caractérisé en ce que** la partie mobile (34) support de l'élément (E) du support coulissant (3) comprend au moins une cale de positionnement avant (38) et une cale de positionnement arrière (39) de l'élément (E).

9. Abri selon l'une des revendications précédentes, **caractérisé en ce qu'**au moins l'un des supports coulissants (3) est équipé de moyens de verrouillage (6) de la partie mobile (34) support de l'élément (E) en position rentrée.

10. Abri selon la revendication 9, **caractérisé en ce que** lesdits moyens de verrouillage (6) comprennent un manchon tubulaire (61) solidaire de ladite partie mobile (34) support de l'élément (E) et un doigt de verrouillage (62) mobile en translation à l'intérieur dudit manchon tubulaire (31) et armé à ressort, **en ce que** la partie fixe (30, 32) du support coulissant (3) présente un logement (304) de réception de l'extrémité extérieure dudit doigt de verrouillage (62), **en ce que** le ressort tend en permanence à maintenir l'extrémité extérieure du doigt de verrouillage (62) dans le logement de réception (304) de la partie fixe du support coulissant (3), en immobilisant ainsi la partie mobile du support coulissant (3) en position rentrée et **en ce que** le doigt de verrouillage (62) peut être déplacé à l'encontre de la force de rappel du ressort pour que son extrémité extérieure sorte dudit logement de réception (304), en libérant ainsi ladite partie mobile (34) du support coulissant (3).

## Patentansprüche

1. Stationärer Schutz (1) zur Aufbewahrung von mindestens einem Energiespeicherelement, "Element" (E) genannt, der mindestens einen Platz (10) zur Aufbewahrung eines Elements umfasst, **dadurch gekennzeichnet, dass** er eine Schiebestütze (3) auf beiden Seiten von jedem Aufbewahrungsplatz (10) umfasst, wobei die zwei Schiebestützen (3) auf der gleichen Höhe und einander gegenüberstehend angeordnet sind, dadurch, dass jede Schiebestütze (3) einen festen Teil (30, 32), der fest mit dem Schutz (1) verbunden ist, und einen beweglichen Teil (34, 36) umfasst, der ausgestaltet ist, um das Element (E) aufzunehmen und zu stützen und um sich in Bezug zu dem festen Teil (30, 32) zwischen einer eingefahrenen Position, in der er sich im Inneren des Schutzes (1) befindet, und einer ausgefahrenen Position verschieben zu können, in der er sich außerhalb des Schutzes (1) befindet, und das Laden und das Entladen des Elements (E) von oben ermöglicht, und dadurch, dass mindestens eine von den Schiebestützen (3) mit Mitteln (7) zur Verriegelung des beweglichen Teils (34, 36) in der ausgefahrenen Position ausgestattet ist.

2. Schutz nach Anspruch 1, **dadurch gekennzeichnet, dass** der bewegliche Teil (34) der Schiebestütze (3), der ausgestaltet ist, um das Element (E) zu stützen, ein Winkelband ist, das die Form eines L-förmigen Winkelprofils aufweist, dessen horizontaler Flügel (342) es ermöglicht, zumindest einen Teil des Elements (E), vorzugsweise einen seitlichen kleinen Flügel davon, zu stützen.

3. Schutz nach Anspruch 1 oder 2, **dadurch gekennzeichnet, dass** die Schiebestützen (3) ausziehbar sind und mindestens einen beweglichen Zwischenteil (31) umfassen, der zwischen dem festen Teil (30, 32) und dem beweglichen Teil (34, 36) der Stütze des Elements (E) eingefügt ist.

4. Schutz nach Anspruch 3, **dadurch gekennzeichnet, dass** die Schiebestütze (3) eine Befestigungslatte (30), eine Gleitschiene (31) und ein Winkelband (34) umfasst, das die Form eines L-förmigen Winkelprofils aufweist, dessen horizontaler Flügel (342) es ermöglicht, zumindest einen Teil des Elements (E), vorzugsweise einen seitlichen kleinen Flügel davon, zu stützen, wobei die Gleitschiene (31) eine Führungsschiene (310) umfasst, die die Form eines I-förmigen Profils aufweist, mit zwei Schiebeleisten (32, 33) versehen ist, die geeignet sind, sich auf beiden Seiten der Führungsschiene (310) zu verschieben, wobei die Befestigungslatte (30) und eine (32) der Schiebeleisten den festen Teil der Schiebestütze (3) bilden, wobei die Führungsschiene (310) den beweglichen Zwischenteil der Schiebestütze (3) bildet und die andere Schiebeleiste (33) und das Winkelband (34) den beweglichen Stützteil des Elements (E) der Schiebestütze (3) bilden.

5. Schutz nach einem der vorhergehenden Ansprüche, **dadurch gekennzeichnet, dass** die beweglichen Teile (34) zum Stützen des Elements (E) aus zwei Schiebestützen (3), die sich auf beiden Seiten eines Aufbewahrungsplatzes (10) befinden, untereinander durch mindestens einen Querträger (35) verbunden sind, derart dass ein Gestell (36) gebildet wird.

6. Schutz nach einem der vorhergehenden Ansprüche, **dadurch gekennzeichnet, dass** die Mittel (7) zur Verriegelung des beweglichen Teils der Schiebestütze (3) in der ausgefahrenen Position einen Hebel (71) umfassen, der in Bezug zu dem beweglichen Teil (34) der Schiebestütze, die das Element (E) stützt, schwenkbar gelagert ist, wobei dieser Hebel (71) eine Einkerbung (72) aufweist, die geeignet ist, einen Verriegelungsstift (44) aufzunehmen, der fest mit dem Schutz (1) verbunden ist, dadurch, dass der Hebel (71) zwischen einer verriegelten Position, in der der Verriegelungsstift (44) in der Einkerbung (72) untergebracht ist und in der der bewegliche Teil (34) der Schiebestütze in der ausgefahrenen Position festgelegt ist, und einer entriegelten Position beweglich ist, in der der Verriegelungsstift (44) sich außerhalb der Einkerbung (72) befindet und in der der bewegliche Teil (34) der Schiebestütze beweglich ist.

7. Schutz nach einem der vorhergehenden Ansprüche, **dadurch gekennzeichnet, dass** der bewegliche Teil (34) zum Stützen des Elements (E) der Schiebestütze mindestens eine Führung (37) zur seitlichen Positionierung des Elements (E) umfasst.

8. Schutz nach einem der vorhergehenden Ansprüche, **dadurch gekennzeichnet, dass** der bewegliche Teil (34) zum Stützen des Elements (E) der Schiebestütze (3) mindestens eine vordere Unterlage (38) zur Positionierung und eine hintere Unterlage (39) zur Positionierung des Elements (E) umfasst.

9. Schutz nach einem der vorhergehenden Ansprüche, **dadurch gekennzeichnet, dass** mindestens eine von den Schiebestützen (3) mit Mitteln (6) zur Verriegelung des beweglichen Teils (34) zum Stützen des Elements (E) in der eingefahrenen Position ausgerüstet ist.

10. Schutz nach Anspruch 9, **dadurch gekennzeichnet, dass** die Verriegelungsmittel (6) eine röhrenförmige Hülse (61), die fest mit dem beweglichen Teil (34) zum Stützen des Elements (E) verbunden ist, und einen Verriegelungsfinger (62) umfassen, der translatorisch im Inneren der röhrenförmigen Hülse (31) beweglich ist und federgespannt ist, dadurch, dass der feste Teil (30, 32) der Schiebestütze (3) einen Sitz (304) zur Aufnahme des äußeren Endes des Verriegelungsfingers (62) aufweist, dadurch, dass die Feder ständig dazu neigt, das äußere Ende des Verriegelungsfingers (62) in dem Aufnahmesitz (304) des festen Teils der Schiebestütze (3) zu halten, indem somit der bewegliche Teil der Schiebestütze (3) in der eingefahrenen Position gehalten wird, und dadurch, dass der Verriegelungsfinger (62) gegen die Rückholkraft der Feder verlagert werden kann, damit sein äußeres Ende aus dem Aufnahmesitz (304) austritt, wodurch somit der bewegliche Teil (34) der Schiebestütze (3) freigegeben wird.

## Claims

1. A stationary shelter (1) for storing at least one energy storage element, a so-called "element" (E), comprising at least one location (10) for storing an element, **characterized in that** it comprises a sliding support (3) on either side of each storage location (10), both sliding supports (3) being positioned at the same height and facing each other, **in that** each sliding support (3) comprises a fixed portion (30, 32) secured to said shelter (1) and a movable portion (34, 36) configured for receiving and supporting said element (E) and for being able to slide relatively to said fixed portion (30, 32) between a retracted position, wherein it is inside the shelter (1) and an outside position, wherein it is outside of the shelter (1) and allows the loading and the unloading of said element (E) from the top and **in that** at least one of the sliding supports (3) is equipped with locking means (7) of the movable portion (34, 36) in the outside position.

2. The shelter according to claim 1, **characterized in that** the movable portion (34) of the sliding support (3) configured for supporting the element (E) is a square having the shape of an L-shaped angle iron for which the horizontal wing (342) gives the possibility of supporting at least one portion of the element (E), preferably a lateral fin of the latter.

3. The shelter according to claim 1 or 2, **characterized in that** said sliding supports (3) are telescopic and comprise at least one intermediate movable portion (31) inserted between the fixed portion (30, 32) and said movable portion (34, 36) supporting the element (E).

4. The shelter according to claim 3, **characterized in that** the sliding support (3) comprises an attachment lath (30), a slider (31) and a square (34) having the shape of an L-shaped angle iron, for which the horizontal wing (342) gives the possibility of supporting at least one portion of the element (E), preferably a lateral fin of the latter, said slider (31) comprising a guiding rail (310) having the shape of an I-profile, provided with two sliding rulers (32, 33) able to slide on either side of said guiding rail (310), the attachment lath (30) and one (32) of the sliding rulers forming the fixed portion of the sliding support (3), the guiding rail (310) forming the intermediate movable portion of the sliding support (3) and the other sliding ruler (33) and the square (34) forming the movable portion supporting the element (E) of the sliding support (3).

5. The shelter according to one of the preceding claims, **characterized in that** the movable portions (34) supporting the element (E) of two sliding supports (3) located on either side of a storage location (10) are connected together through at least one crosspiece (35) so as to form a cradle (36).

6. The shelter according to one of the preceding claims, **characterized in that** the locking means (7) of the movable portion of the sliding support (3) in the outside position comprise a lever (71) pivotally mounted relatively to the movable portion (34) of the sliding support which supports the element (E), this lever (71) having a notch (72) able to receive a locking pin (44) secured to the shelter (1), and **in that** said lever (71) is movable between a locked position, wherein the locking pin (44) is accommodated in the notch (72) and wherein said movable portion (34) of the sliding support is immobilized in the outside position, and an unlocked position, wherein the locking pin (44) is outside the notch (72) and wherein the movable portion (34) of the sliding support is movable.

7. The shelter according to one of the preceding claims, **characterized in that** the movable portion (34) supporting the element (E) of the sliding support comprises at least one lateral positioning guide (37) of the element (E).

8. The shelter according to one of the preceding claims, **characterized in that** the movable portion (34) supporting the element (E) of the sliding support (3) comprises at least one front positioning shim (38) and a rear positioning shim (39) of the element (E).

9. The shelter according to one of the preceding claims, **characterized in that** at least one of the sliding supports (3) is equipped with locking means (6) of the movable portion (34) supporting the element (E) in the retracted position.

10. The shelter according to claim 9, **characterized in that** said locking means (6) comprise a tubular sleeve (61) secured to said movable portion (34) supporting the element (E) and a locking finger (62) movable in translation inside said tubular sleeve (31) and armed with a spring, **in that** the fixed portion (30, 32) of the sliding support (3) has a housing (304) for receiving the outer end of said locking finger (62), **in that** the spring permanently tends to maintain the outer end of the locking finger (62) in the housing for receiving (304) the fixed portion of the sliding support (3), by thereby immobilizing the movable portion of the sliding support (3) in the retracted position and **in that** the locking finger (62) may be moved against the return force of the spring so that its outer end emerges from said receiving housing (304), by thereby releasing said movable portion (34) from the sliding support (3).
